## Europäisches Patentamt
## European Patent Office
## Office européen des brevets

(1) Veröffentlichungsnummer: **0 317 872**
**A1**

# EUROPÄISCHE PATENTANMELDUNG

(21) Anmeldenummer: **88118989.8**

(22) Anmeldetag: **14.11.88**

(51) Int. Cl.⁴: **G06F 11/16 , G06F 1/00**

Die Bezeichnung der Erfindung wurde geändert (Richtlinien für die Prüfung im EPA, A-III, 7.3).

(30) Priorität: **25.11.87 US 125628**

(43) Veröffentlichungstag der Anmeldung:
**31.05.89 Patentblatt 89/22**

(84) Benannte Vertragsstaaten:
**CH DE ES FR GB IT LI**

(71) Anmelder: **Siemens Aktiengesellschaft Berlin und München**
**Wittelsbacherplatz 2**
**D-8000 München 2(DE)**

(72) Erfinder: **Honeck, Karl-Heinz**
**In den Oberwiesen 2**
**D-6741 Hochstadt(DE)**
Erfinder: **Johnson, David**
**3401 SW Stonebrook Drive**
**Portland Oregon 97201(US)**
Erfinder: **Neugebauer, Manfred**
**In der Reuth 132**
**D-8520 Erlangen(DE)**
Erfinder: **Teutsch, Walter**
**Karl-Broeger-Strasse 6**
**D-8520 Erlangen(DE)**
Erfinder: **Kini, Vittal M.**
**14190 Northwest Burton Street**
**Portland Oregon 97229(US)**
Erfinder: **Stacey, Steven C.**
**192 S.E. 24th Avenue**
**Hillsboro Oregon 97123(US)**

(54) **Schaltungsanordnung mit einem Prozessor, mindestens zwei Schreib-Lese-Speichern und einer Stromversorgungseinrichtung.**

(57) Damit Ausfälle der Stromversorgungseinrichtung (SV2,SV3) für zwei parallel betreibbare Schreib-Lese-Speicher (RAM1,RAM2) nicht zu irreversiblen Schäden für den Datenverkehr führen, sind für den Betrieb der Speicher (RAM1,RAM2) zwei parallele Stromversorgungsschaltungen (SV2 und SV3) vorgesehen, die jede jeweils in der Lage sind, den Betriebsstrom eines der Speicher (RAM2) und den Bereitschaftsstrom des anderen Speichers (RAM1) zu liefern. Die Stromversorgungsschaltungen (SV1,SV2,SV3) sind durch Kondensatoren so gepuffert. daß bei einer Störung einer der Stromversorgungsschaltungen (SV1,SV2,SV3) die Ausgangsspannung von einer regulären Betriebsspannung ($U2_B$) auf eine minimale Betriebsspannung ($U2_M$) ab einer Schwellwertspannung ($U2_S$) in einer Zeitspanne absinkt, die größer ist als die Zeit zum Retten der relevanten Daten in den durch eine Überwachungseinrichtung bei Absinken der Ausgangsspannung ($U2$) auf die Schwellwertspannung ($U2_S$) in Bereitschaft schaltbaren Speicher (RAM1).

FIG 1

## Schaltungsanordnung mit einem Prozessor und mindestens zwei Schreib-Lese-Speichern

Die Erfindung bezieht sich auf eine Schaltungsanordnung, bei der zu einem Prozessor mindestens ein Schreib-Lese-Speicher für einen adressengesteuerten Datenverkehr vorgesehen ist.

Eine solche Konfiguration ist vielen handelsüblichen Mikrocomputersystemen zu eigen. Damit bei derartigen Schaltungsanordnungen bei Ausfall der zugehörigen Stromversorgung sichergestellt wird, daß die Daten in Schreib-Lese-Speicher erhalten werden, können beispielsweise die beiden folgenden Maßnahmen getroffen werden.
- Pufferung des Schreib-Lese-Speichers gegen Netzausfall.
- Redundante Auslegung des Schreib-Lese-speichers gegen interne Fehler in einem Schreib-Lese-Speicher.

Der Aufbau der Stromversorgung bei einer Kombination beider Maßnahmen bedingt jedoch einen technisch relativ hohen Aufwand, da die Einrichtung in diesem Fall für den doppelten Betriebsstrom auszulegen ist.

Aufgabe der Erfindung ist es, eine Schaltungsanordnung der eingangs genannten Art so auszubilden, daß mit geringem technischen Aufwand bei einem Defekt der Stromversorgungseinrichtung die Daten in Schreib-Lese-Speicher erhalten bleiben.

Gemäß der Erfindung wird diese Aufgabe bei Ausfällen der Stromversorgung für die Speicher dadurch gelöst, daß für die Schreib-Lese-Speicher eine Stromversorgungseinrichtung vorgesehen ist, die zwei parallele Stromversorgungsschaltungen aufweist. wobei jede Stromversorgungsschaltung maximal einen Strom liefert, welcher der Summe des Bereitschaftsstroms eines ersten Schreib-Lese-Speichers und des Betriebsstroms eines zweiten Schreib-Lese-Speichers entspricht, daß die Ausgangsspannung der Stromversorgungsschaltungen kapazitiv so gepuffert ist, daß bei Entnahme des Betriebsstroms für beide Schreib-Lese-Speicher bei Ausfall einer der Stromversorgungsschaltungen die Ausgangsspannung von einer unterhalb der regulären Betriebsspannung liegenden Schwellwertspannung zu einer minimal zulässigen Betriebsspannung innerhalb einer Zeitspanne sinkt, die mindestens der Zeitdauer zum Umschalten des ersten Schreib-Lese-Speichers vom Betriebszustand in einen Bereitschaftszustand entspricht, und daß beim Absinken der Ausgangsspannung auf die Schwellwertspannung von einer Überwachungseinrichtung der erste Schreib-Lese-Speicher in den Bereitschaftszustand setzbar ist. Da der Strombedarf im Bereitschaftszustand relativ gering ist, kann die Stromversorgungseinrichtung in ihrer Leistung gegenüber der eingangs genannten Ausgestaltung ganz erheblich geringer ausgelegt werden. Die beiden Stromversorgungsschaltungen der Stromversorgungseinrichtung können netz- und oder batteriegespeist ausgebildet sein.

Zum anderen wird die eingangs genannte Aufgabe bei Ausfällen der ungepufferten Stromversorgung für den Prozessor dadurch gelöst, daß für den Prozessor eine weitere Stromversorgungsschaltung der Stromversorgungseinrichtung vorgesehen ist, daß die Ausgangsspannung dieser Stromversorgungsschaltung kapazitiv gepuffert ist, so daß bei Ausfall dieser Stromversorgungsschaltung die Ausgangsspannung von einer unterhalb der regulären Betriebsspan-nung liegenden Schwellwertspannung zu einer minimal zulässigen Betriebsspannung innerhalb einer Zeitspanne sinkt, die mindestens der zeitdauer zum Umschalten des ersten Schreib-Lese-Speichers vom Betriebszustand in einen Bereitschaftszustand entspricht, und daß bei Absinken der Ausgangsspannung auf die Schwellwertspannung von der Überwachungseinrichtung der erste Schreib-Lese-Speicher in den Bereitschaftszustand setzbar ist. `

Wenn ein das Setzen des ersten Schreib-Lese-Speichers in den Bereitschaftszustand anzeigendes Steuersignal an den Prozessor leitbar ist, kann bei Ausfall einer der Stromversorgungsschaltungen für die Schreib-Lese-Speicher der Prozessor unmittelbar über diesen Störungsfall informiert werden. Allerdings wäre es auch möglich, daß vom Prozessor jeweils der Status des ersten Schreib-Lese-Speichers bedarfsweise abgefragt wird und anhand dieser Abfrage das Vorliegen eines Störungsfalls detektiert wird.

Ein Rücksetzen des ersten Schreib-Lese-Speichers durch ein gesondertes Rücksetzsignal stellt sicher, daß die Inbetriebnahme nach einem Störungsfall nicht ohne weiteres möglich ist, sondern daß dazu eine Hilfshandlung vorzunehmen ist.

Ein Ausführungsbeispiel der Erfindung ist in der Zeichnung dargestellt und wird im folgenden näher erläutert. Dabei zeigen:

Fig. 1 eine erfindungsgemäße Schaltungsanordnung,

Fig. 2 ein erstes Spannungs-Zeit-Diagramm und

Fig. 3 ein zweites Spannungs-Zeit-Diagramm.

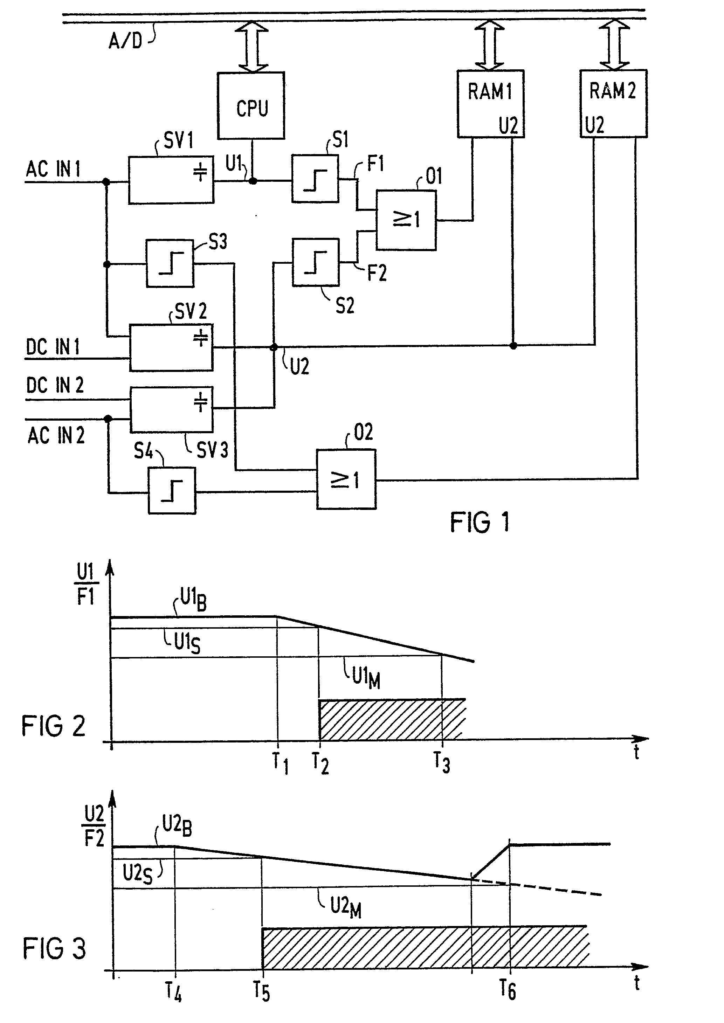

In der Darstellung gemäß Fig.1 ist ein Prozessor CPU gezeigt, der über einen Adreßbus A und einen Datenbus D (Adreßbus A und Datenbus D können auch als redundante Systeme aufgebaut sein) mit zwei im regulären Betrieb parallel betriebenen Schreib-Lese-Speichern RAM1 und RAM2 im bidirektionalen Datenaustausch steht. Zur Stromversorgung des Prozessors CPU und der Schreib-Lese-Speicher RAM1 und RAM2 ist eine Stromversorgungseinrichtung vorgesehen, die aus einer netzgespeisten Stromversorgungsschaltung SV1 für den Prozessor CPU, sowie parallelgeschalteten Stromversorgungsschaltungen SV2 und SV3 für die Schreib-Lese-Speicher RAM1 und RAM2 besteht. Die Stromversorgungsschaltungen SV2 und SV3 sind dabei sowohl vom Netz wie auch von einer Batterie eingangsseitig gespeist. Die Sicherung der Stromversorgung über eine Batterie verhindert einen Verlust von wichti gen Daten in den Schreib-Lese-Speichern RAM1 und RAM2 im Fall von Netzausfällen.

Von der Stromversorgungsschaltung SV1 wird eine Ausgangsspannung $U1$ zum Betrieb des Prozessors CPU generiert, von den Stromversorgungsschaltungen SV2 und SV3 gelangt eine Ausgangsspannung $U2$ an die zugehörigen Schreib-Lese-Speicher RAM1 und RAM2. Die Ausgangsspannungen $U1$ und $U2$ sind jeweils kapazitiv gepuffert, was durch entsprechende Kondensatoren in den Stromversorgungsschaltungen SV1, SV2 und SV3 bewerkstelligt werden kann. Die puffernden Kapazitäten könnten jedoch als Kondensatoren auch an beliebigen anderen Orten angeordnet sein. Wesentlich ist nur, daß diese Kondensatoren mit der Ausgangsspannung $U1$ bzw. $U2$ jeweils beaufschlagt werden.

Die Stromversorgungsschaltung SV1 ist so ausgebildet, daß diese den maximalen Betriebsstrom des Prozessors CPU liefern kann, die Stromversorgungseinrichtungen SV2 und SV3 sind so ausgelegt, daß diese jeweils einzeln den Bereitschaftsstrom des ersten Schreib-Lese-Speichers RAM1 und den Betriebsstrom des zweiten Schreib-Lese-Speichers RAM2 liefern können.

Wenn beide Stromversorgungsschaltungen SV2 und SV3 ungestört sind, können demzufolge beide Schreib-Lese-Speicher RAM1 und RAM2 in Betrieb sein, wenn jedoch eine der Stromversorgungsschaltungen SV2 und SV3 gestört ist, ermöglicht die Auslegung des maximalen Ausgangsstroms der Stromversorgungsschaltungen SV2 und SV3 zwar den weiteren Betrieb des Schreib-Lese-Speichers RAM2, jedoch wird dann auf den möglichen redundanten Betrieb des Schreib-Lese-Speichers RAM1 verzichtet und die zum Zeitpunkt des Störungsfalls vorliegenden Daten werden in den Schreib-Lese-Speicher RAM1 übernommen, der nach Retten der Daten in seinen Bereitschaftszustand übergeht.

Zur Erkennung des Störungsfalls ist eine Überwachungseinrichtung UE (gestrichelt angedeutet) vorgesehen. die zwei Schwellenwert stufen S1 bzw. S2 beinhaltet. die beim Unterschreiten einer Schwellwertspannung $U1_S$ der Ausgangsspannung

$U1$ bzw. einer Schwellwertspannung $U2_S$ der Ausgangsspannung $U2$ jeweils ein Fehlersignal F1 bzw. F2 an ein ODER-Glied 0 liefert, dessen Ansprechen einen Speicher SP in einen den Störungsfall anzeigenden Zustand versetzt.

Bei Vorliegen einer Störung wird dann über den Ausgang des Speichers SP zum einen ein Leuchtmelder L wirksamgeschaltet, zum anderen wird über eine Steuerleitung der Schreib-Lese-Speicher RAM1 veranlaßt, vom Betriebszustand in den Bereitschaftszustand zu wechseln.

Der jeweilige Zustand des Schreib-Lese-Speichers RAM1 kann zwar über den Adreßbus A und den Datenbus D oder auch über einen der Übersichtlichkeit halber nicht dargestellten Steuerbus vom Prozessor CPU abgefragt werden, jedoch könnte eine Störung der Stromversorgungsschaltungen SV2 bzw. SV3, der sich durch Ansprechen der Schwellwertstufe S2 zeigt, über eine gesonderte Leitung LT direkt an den Prozessor CPU gemeldet werden.

Zur Auslegung der Schwellwertspannungen $U1_S$ und $U2_S$ wird auf die Fig.2 bzw. Fig.3 mit zugehörigem Text verwiesen.

Die Darstellung gemäß Fig.2 zeigt im wesentlichen ein Spannungs-Zeit-Diagramm der Ausgangsspannung $U1$ der Stromversorgungsschaltung SV1. Vom Koordinatenursprung bis zu einem Zeitpunkt T1 der Zeit $t$ möge eine reguläre Betriebsspannung $U1_B$ vorliegen. Zum Zeitpunkt T1 sei ein Störungsfall der Stromversorgungsschaltung SV1 angenommen, der dazu führt, daß die kapazitiv gepufferte Ausgangsspannunbg $U1$ der Stromversorgungsschaltung SV1 entsprechend dem entnommenen Betriebsstroms des Prozessors CPU absinkt. Das Absinken von der regulären Betriebsspannung $U1_B$ bis zu einer minimal zulässigen Betriebsspannung $U1_M$ erfolgt in etwa linear, wobei die resultierende Neigung vom Zeitpunkt des Störungsfalles T1 bis zum Zeitpunkt T3, an dem die minimal zu lässige Betriebsspannung für den Prozessor CPU vorliegt, von der Größe der die Ausgangsspannung $U1$ puffernden Kapazität abhängt (als Störungsfall ist dabei ein ausgangsseitiger Kurzschluß der Stromversorgungsschaltung SV1 nicht berücksichtigt). Je größer die puffernde Kapazität für die Ausgangsspannung $U1$ ist, desto größer ist auch die Zeitspanne zwischen den Zeitpunkten T1 und T3. Diese Zeitspanne wird so gewählt, daß sie größer ist als die systembedingte Zeitdauer zum Retten der im Störungsfall aktuellen Daten in den ersten Schreib-Lese-Speichers RAM1. Dementsprechend ergibt sich eine unterhalb der regulären Betriebsspannung $U1_B$ und oberhalb der minimalen Betriebsspannung $U1_M$ liegende Schwellwertspannung $U1_S$, die im Diagramm gemäß Fig.2 zum Zeitpunkt T2 erreicht wird. Die Zeitspanne zwischen dem Zeitpunkt T2 und dem Zeitpunkt T3 steht dann zum Retten der aktuellen Daten in den ersten Schreib-Lese-Speicher RAM1 zur ·Verfügung.

Die Tatsache, daß ab dem Zeitpunkt T2 von der Schwellwertstufe S1 ein Fehlersignal F1 ausgegeben wird, ist in der Darstellung gemäß Fig.2 dadurch ausgedrückt, daß ab diesem Zeitpunkt ein schraffierter Balken angedeutet ist.

Im Ausführungsbeispiel gemäß Fig.2 ist die Schwellwertspannung relativ nahe der regulären Betriebsspannung $U1_B$ gelegen, jedoch könnte durch Steigern der Ausgangskapazität für die Stromversorgungsschaltung SV1 die Schwellwertspannung $U1_S$ wesentlich näher der minimalen Betriebsspannung $U1_M$ gewählt sein. Die Wahl von erstrebter Differenz zwischen regulärer Betriebsspannung $U1_B$ und Schwellwertspannung $U1_S$ und demgemäß der entsprechenden Ausgangskapazität der Stromversorgungsschaltung SV1 liegt im Ermessen des jeweiligen Anwenders.

In der Darstellung gemäß Fig.3 ist die Ausgangsspannung U2 der Stromversorgungsschaltungen SV2 und SV3 in Abhängigkeit von der Zeit t dargestellt. Es ist zunächst angenommen, daß die Ausgangsspannung einen regulären Wert $U2_B$ aufweist und zum Zeit punkt eines Störungsfalls T4 bis zum Zeitpunkt T6 auf die minimal zulässige Betriebsspannung $U2_M$ absinkt. Auch hier ist angenommen, daß vom Erreichen einer Schwellwertspannung $U2_S$ zum Zeitpunkt T5 eine Zeitspanne für den Betrieb der Einrichtung verbleibt, innerhalb welcher der Schreib-Lese-Speicher RAM1 die relevanten Daten retten kann. Da ab einem Zeitpunkt T5 von der Schwellwertstufe S2 das Fehlersignal F2 vorliegt, ist auch in diesem Diagramm ein entsprechender schraffierter Balken angedeutet. Der Zusammenhang zwischen Lage der Schwellwertspannung $U2_S$ zur Betriebsspannung $U2_B$ und Zeitspanne vom Zeitpunkt T5 zum Zeitpunkt T6 entspricht den Verhältnissen zwischen Schwellwertspannung $U1_S$, Betriebsspannung $U1_B$ und der Zeitspanne vom Zeitpunkt T2 zum Zeitpunkt T3. Diese Verhältnisse sind im Zusammenhang mit Fig.2 bereits ausführlich dargelegt worden.

## Ansprüche

1. Schaltungsanordnung, bei der zu einem Prozessor mindestens ein Schreib-Lese-Speicher für einen adressengesteuerten Datenverkehr vorgesehen ist, **dadurch gekennzeichnet,** daß für die Schreib-Lese-Speicher (RAM1, RAM2) eine Stromversorgungseinrichtung vorgesehen ist, die zwei parallele Stromversorgungsschaltungen (SV2, SV3) aufweist, wobei jede Stromversorgungsschaltung (SV2, SV3) maximal einen Strom liefert, welcher der Summe des Bereitschaftsstroms eines ersten Schreib-Lese-Speichers (RAM1) und des Betriebsstroms eines zweiten Schreib-Lese-Speichers (RAM2) entspricht, daß die Ausgangsspannung der Stromversorgungsschaltungen (SV2,SV3) kapazitiv so gepuffert ist, daß bei Entnahme des Betriebsstroms für beide Schreib-Lese-Speicher (RAM1,RAM2) bei Ausfall einer der Stromversorgungsschaltungen (RAM1 bzw. RAM2) die Ausgangsspannung (U2) von einer unterhalb der regulären Betriebsspannung ($U2_B$) liegenden Schwellwertspannung ($U2_S$) zu einer minimal zulässigen Betriebsspannung ($U2_M$) innerhalb einer Zeitspanne (T5 bis T6) sinkt, die mindestens der Zeitdauer zum Umschalten des ersten Schreib-lese-Speichers (RAM1) vom Betriebszustand in einen Bereitschaftszustand entspricht, und daß beim Absinken der Ausgangsspannung (U2) auf die Schwellwertspannung ($U2_S$) von einer Überwachungseinrichtung (UE) der erste Schreib-Lese-Speicher (RAM1) in den Bereitschaftszustand setzbar ist.

2. Schaltungsanordnung, bei der zu einem Prozessor mindestens ein Schreib-Lese-Speicher für einen adressengesteuerten Datenverkehr vorgesehen ist, **dadurch gekennzeichnet,** daß für den Prozessor (CPU) eine weitere Stromversorgungsschaltung (SV1) der Stromversorgungseinrichtung vorgesehen ist, daß die Ausgangsspannung dieser Stromversorgungsschaltung (SV1) kapazitiv gepuffert ist, so daß bei Ausfall dieser Stromversorgungsschaltung die Ausgangsspannung (U1) von einer unterhalb der regulären Betriebsspannung ($U1_B$) liegenden Schwellwertspannung ($U1_S$) zu einer minimal zulässigen Betriebsspan nung ($U1_M$) innerhalb einer Zeitspanne (T2 bis T3) sinkt, die mindestens der Zeitdauer zum Umschalten des ersten Schreib-Lese-Speichers (RAM1) vom Betriebszustand in einen Bereitschaftszustand entspricht und daß bei Absinken der Ausgangsspannung (U1) auf die Schwellwertspannung ($U1_S$) von der Überwachungseinrichtung (UE) der erste Schreib-Lese-Speicher (RAM1) in den Bereitschaftszustand setzbar ist.

3. Schaltungsanordnung nach Anspruch 1 oder 2, **dadurch gekennzeichnet,** daß ein das Setzen des ersten Schreib-Lese-Speichers (RAM1) in den Bereitschaftszustand anzeigendes Steuersignal an den Prozessor (CPU) leitbar ist.

4. Schaltungsanordnung nach einem der vorstehenden Ansprüche, **dadurch gekennzeichnet,** daß ein Rücksetzen des ersten Schreib-Lese-Speichers (RAM1) nur durch ein gesondertes Rücksetzsignal auslösbar ist.

87 P 7442

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-3 980 935 (WORST) <br> * Spalte 2, Zeilen 21-53 * <br> --- | 1 | G 06 F 11/16 <br> G 06 F 1/00 |
| A | US-A-4 375 663 (ARCARA et al.) <br> * Spalte 2, zeilen 5-68 * <br> --- | 1 | |
| A | PATENT ABSTRACTS OF JAPAN, Band 2, Nr. 40 (E-022), 16. März 1978, Seite 306 E 78; & JP-A-53 5935 (MITSUBISHI DENKI K.K.) 19-01-1978 <br> * Zusammenfassung * <br> --- | 1 | |
| A | DIGEST OF PAPERS OF THE SPRING COMPCON'80, San Francisco, 25.-28. Februar 1980, Seiten 125-133, IEEE, New York, US; F.G. SNYDER: "A comparison of redundant computer configurations" <br> * Seite 127, linke Spalte, Zeilen 17-24 * <br> --- | 1 | |
| A | EP-A-0 075 825 (PITNEY BOWES) <br> * Anspruch 1 * <br> ----- | 2 | RECHERCHIERTE SACHGEBIETE (Int. Cl.4) <br><br> G 06 F 1/00 <br> G 06 F 11 <br> G 11 C 5/00 |

Der vorliegende Recherchenbericht wurde für alle Patentansprüche erstellt

| Recherchenort | Abschlußdatum der Recherche | Prüfer |
|---|---|---|
| DEN HAAG | 15-12-1988 | HERREMAN,G.L.O. |